# EUROPEAN PATENT APPLICATION

(11) **EP 1 509 069 A2**
(43) Date of publication of application: **23.02.2005**
(21) Application number: 04019719.6
(22) Date of filing: 19.08.2004
(51) Int. Cl.: H05K 1/11, H05K 3/42

(54) **Double-sided wiring circuit board and process for producing the same**

(30) Priority: 22.08.2003 JP 2003298283
(71) Applicant: NITTO DENKO CORPORATION, Osaka (JP)
(72) Inventor: Naito, Toshiki Nitto Denko Corporation, Ibaraki-shi Osaka (JP); Omote, Toshihiko Nitto Denko Corporation, Ibaraki-shi Osaka (JP)
(74) Representative: Grünecker, Kinkeldey, Stockmair & Schwanhäusser Anwaltssozietät

(57) **Abstract**

The invention provides a double-sided wiring circuit board (100) which comprises: an insulating layer (10a) having a through-hole (10V) formed therein and having a first side and a second side; a conductor layer (10b) formed on the first side of the insulating layer (10a); a thin metal film (12) formed on the second side of the insulating layer (10a), on the inner circumferential surface of the through-hole (10V), and on the part of the conductor layer (10b) that is located in the through-hole (10V); and a deposit layer (10M) formed by electroplating on the thin metal film (12), wherein the through-hole (10V) has an inner circumferential wall which inclines so that the inner diameter of the hole gradually increases from the first side to the second side of the insulating layer (10a), and wherein the angle of the inclination between the first side of the insulating layer and the inner circumferential wall being from 40° to 70°. Also disclosed is a production process thereof.

## Description

### FIELD OF THE INVENTION

The present invention relates to a double-sided wiring circuit board in which conductor layers disposed respectively on both sides of an insulating layer are electrically connected to each other through through-holes (via holes) formed in the insulating layer. The invention also relates to a process for producing the wiring circuit board.

### BACKGROUND OF THE INVENTION

In the field of wiring circuit boards, there have been demands for noise reduction in a high-frequency region, increase in wiring density, and the like because of the trend toward the size and thickness reduction in electronic appliances and the application to cell phones, etc.

A wiring circuit board having a multilayer structure has been developed in order to satisfy those requirements. This wiring circuit board is a double-sided wiring circuit board comprising an insulating layer and a conductor layer formed on each side thereof (see, for example, patent document 1).

In such a double-sided wiring circuit board, it is necessary to form passages which connect the conductor layers separated by an insulating layer. Connecting structures such as through-hole via structures and blind via structures have hence been put to practical use for connecting the conductor layers disposed respectively on both sides to each other.

In double-sided wiring circuit boards required to have fine wiring patterns, the size of vias can be minimized by applying a blind via structure, which is easily made to have a structure in which the vias are filled with a conductive substance. Use of the blind via structure can advantageously realize a reduction in the overall sizes of products, increase in the degree of freedom of wiring, and superposition of a wiring pattern on another wiring pattern.

Methods for forming wiring patterns in such double-sided wiring circuit boards include the additive wiring formation method, semiadditive wiring formation method, and subtractive wiring formation method.

The wiring pitch in double-sided wiring circuit boards is desired to be reduced (e.g., to a wiring pitch of 50 µm or smaller). When a reduction in wiring pitch is taken into account, it is difficult with the subtractive wiring formation method to form wiring patterns at a high percent non-defective. Introduction of the additive wiring formation method and the semiadditive wiring formation method is hence being investigated.

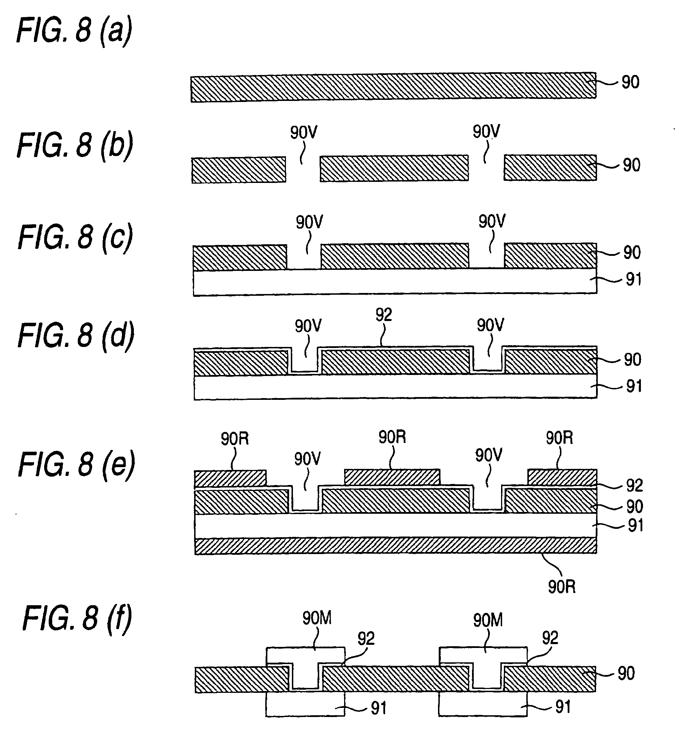

Figs. 8 are views illustrating an example of the procedure for producing a double-sided wiring circuit board having a blind via structure by the conventional semiadditive wiring formation method.

In the additive wiring formation method, wiring patterns formed respectively on both sides are electrically connected to each other by a deposit layer formed by plating. The deposit layer is formed by a technique such as electroless plating or electroplating. From the standpoint of the rate of forming a film as a conductor layer, electroplating is frequently used.

First, an insulating layer 90 made of, e.g., a resin is prepared as shown in Fig. 8(a). Subsequently, as shown in Fig. 8(b), via holes 90V (openings) are formed in the insulating layer 90. The via holes 90 are formed by a technique employing a laser beam, punching with a die, chemical etching, or the like.

A conductor layer 91 composed by, e.g., a copper foil is then laminated to one side of the insulating layer 90 with an adhesive as shown in Fig. 8(c). Thereafter, a thin metal film 92 is formed on the upper side of the insulating layer 90, on the inner circumferential surfaces of the via holes 90V, and on those parts of the upper side of the conductor layer 91 that are located in the via holes 90V, as shown in Fig. 8(d), in preparation for electroplating. The thin metal film 92 is formed by electroless plating, sputtering, etc.

Subsequently, a plating resist layer 90R is formed in given regions on the surface of the thin metal film 92 and also formed on the conductor layer 91 as shown in Fig. 8 (e).

Electroplating is conducted using the thin metal film 92 as a plating electrode to form a deposit layer 90M. Thereafter, the plating resist layers 90R on the thin metal film 92 and on the conductor layer 91 are peeled off and the thin metal film 92 thus exposed is removed.

Subsequently, an etching resist layer (not shown) is formed in given regions on the surface of the conductor layer 91 and the conductor layer 91 is etched as shown in Fig. 8 (f). After the etching of the conductor layer 91, the etching resist layer is removed. Thus, wiring patterns formed respectively by the deposit layer 90M and the conductor layer 91 are obtained on the respective side of the insulating layer 90.
Patent Document 1: JP 09-186454 A
Patent Document 2: JP 2002-299386 A

Incidentally, in the case where the thin metal film 92 is formed by electroless plating, it is necessary to cause an electroless-plating solution to penetrate into the via holes 90V.

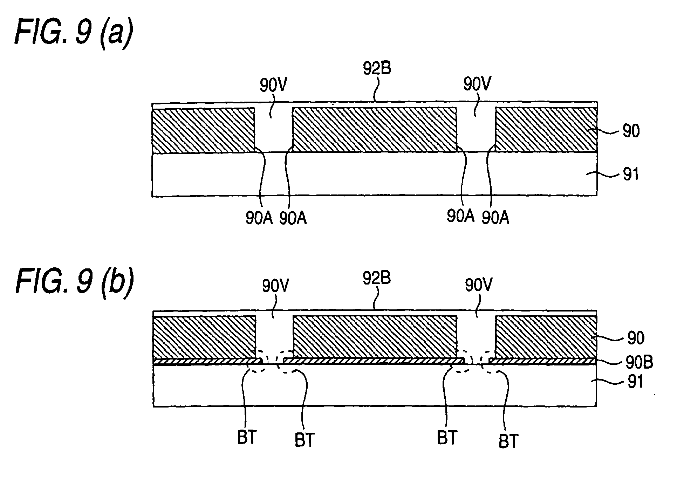

Figs. 9 are diagrammatic sectional views illustrating the state of an electroless-plating solution which has penetrated into via holes 90V according to conventional techniques.

As shown in Fig. 9 (a), when an electroless-plating solution 92B is caused to penetrate into via holes 90V, there are cases where air bubbles 90A which have come into the via holes 90V are trapped at the edges of the via hole bottoms. When air bubbles 90A are thus trapped, a thin metal film 92 is not formed in these areas and this results in defects also in the deposit layer 90M to be formed by electroplating in a later step as shown in Fig. 8(f).

Methods for preventing the trapping of air bubbles 90A in via holes 90V have hence been proposed (see, for example, patent document 2).

For example, as the method for preventing the trapping of air bubbles 90A in via holes 90V, there has been proposed a method in which upon laminating an insulating layer 90 with a conductor layer 91 as shown in Fig. 8(c), an adhesive is applied so as to protrude into the via holes 90V.

In this case, not only an adhesive layer 90B is formed between the insulating layer 90 and the conductor layer 91 but also adhesive protrusions BT are formed in the via holes 90V, as shown in Fig. 9(b). As a result, the edges of the bottoms of the via holes 90V become non-abrasive and, hence, air bubbles 90A which have come into the via holes 90V are less apt to be trapped at the edges of the via hole bottoms.

However, the method described above can be used only when the lamination of the insulating layer 90 to the conductor layer 91 is conducted with an adhesive.

On the other hand, when the thin metal film 92 is formed by sputtering, there are cases where the thin metal film 92 is less apt to be formed in an even thickness on the inner circumferential surfaces of the via holes 90V. Also in such cases, the deposit layer 90M to be formed by electroplating in a later step will have defects.

### SUMMARY OF THE INVENTION

An object of the invention is to provide a double-sided wiring circuit board which is sufficiently prevented from having defects in a deposit layer formed by plating and can realize high-density wiring patterns.

Another object of the invention is to provide a process for producing the wiring circuit board.

Other objects and effects of the invention will become apparent from the following description.

In a first aspect, the present invention provides a double-sided wiring circuit board which comprises:
an insulating layer having a through-hole formed therein and having a first side and a second side;
a conductor layer formed on the first side of the insulating layer;
a thin metal film formed on the second side of the insulating layer, on the inner circumferential surface of the through-hole, and on the part of the conductor layer that is located in the through-hole; and
a deposit layer formed by electroplating on the thin metal film,
wherein the through-hole has an inner circumferential wall which inclines so that the inner diameter of the hole gradually increases from the first side to the second side of the insulating layer, and
wherein the angle of the inclination between the first side of the insulating layer and the inner circumferential wall being from 40° to 70°.

In the double-sided wiring circuit board according to the first aspect of the invention, the through-hole has been formed so as to have an inner circumferential wall having an angle of inclination of 70° or smaller with the first side of the insulating layer. Because of this, not only the thin metal film is evenly formed on the inner circumferential surface of the through-hole and on the part of the conductor layer that is located in the through-hole, but also the thin metal film has no defects at the edge of the bottom of the through-hole. As a result, the deposit layer to be formed by electroplating on the thin metal film is sufficiently prevented from having defects.

In addition, the through-hole has been formed so that the inner circumferential wall thereof has an angle of inclination of 40°C or larger with the first side of the insulating layer. Because of this, the decrease in reliability of electrical connection due to a too small area of through-hole on the first side is prevented, and also the short-circuiting between the conductor layer and another wiring due to a too large area of through-hole on the second side is prevented.

Consequently, the deposit layer formed by electroplating is sufficiently prevented from having defects, and a high-density wiring pattern of the conductor layer is realized. Furthermore, the electrical reliability of the deposit layer formed by electroplating and of the conductor layer is improved.

The thin metal film may be a film deposited by electroless plating. In this case, air bubbles which have come into the through-hole during the penetration of an electroless-plating solution into the through-hole are less apt to be trapped at the edge of the bottom. Consequently, the deposit layer to be formed by electroplating is sufficiently prevented from having defects caused by trapped air bubbles.

The thin metal film may be a film deposited by sputtering. In this case, not only the sputtering film is evenly formed on the inner circumferential surface of the through-hole and on the part of the conductor layer that is located in the through-hole, but also the sputtering film has no defects at the edge of the bottom of the through-hole. As a result, the deposit layer to be formed by electroplating on this sputtering film is sufficiently prevented from having defects.

In a second aspect, the invention provides a process for producing a double-sided wiring circuit board which comprises the steps of:
preparing a two-layer substrate comprising an insulating layer having a first side and a second side and a first conductor layer formed on the first side of the insulating layer;
forming a through-hole in the insulating layer so as to expose the first conductor layer,
forming a thin metal film on the second side of the insulating layer, on the inner circumferential surface of the through-hole, and on the part of the first conductor layer that is located in the through-hole; and
depositing a second conductor layer by electroplating on the thin metal film,
wherein the through-hole forming step includes a step of forming an inner circumferential wall of the through-hole so as to incline at an angle of from 40° to 70° with the first side of the insulating layer so that the inner diameter of the hole gradually increases from the first side to the second side of the insulating layer.

In the process for producing a double-sided wiring circuit board according to the second aspect of the invention, the through-hole is formed so as to have an inner circumferential wall having an angle of inclination of 70° or smaller with the first side of the insulating layer. Because of this, not only the thin metal film is evenly formed on the inner circumferential surface of the through-hole and on the part of the first conductor layer that is located in the through-hole, but also the thin metal film has no defects at the edge of the bottom of the through-hole. As a result, the deposit layer to be formed by electroplating on the thin metal film is sufficiently prevented from having defects.

In addition, the through-hole is formed so that the inner circumferential wall thereof has an angle of inclination of 40°C or larger with the first side of the insulating layer. Because of this, the decrease in reliability of electrical connection due to a too small area of through-hole on the first side is prevented, and also the short-circuiting between the second conductor layer and another wiring due to a too large area of through-hole on the second side is prevented.

Consequently, the deposit layer formed by electroplating is sufficiently prevented from having defects, and high-density wiring patterns of the first and second conductor layers are realized. Furthermore, the electrical reliability of the deposit layer formed by electroplating and of the first and second conductor layers is improved.

The thin metal film may be deposited by electroless plating. In this case, air bubbles which have come into the through-hole during the penetration of an electroless-plating solution into the through-hole are less apt to be trapped at the edge of the bottom. Consequently, the deposit layer to be formed by electroplating is sufficiently prevented from having defects caused by trapped air bubbles.

The thin metal film may be deposited by sputtering. In this case, not only the sputtering film is evenly formed on the inner circumferential surface of the through-hole and on the part of the first conductor layer that is located in the through-hole, but also the sputtering film has no defects at the edge of the bottom of the through-hole. As a result, the deposit layer to be formed by electroplating on this sputtering film is sufficiently prevented from having defects.

The insulating layer may be formed from a flexible resin. In this case, a flexible double-sided wiring circuit board which has high-density wiring patterns and is highly reliable is realized.

### BRIEF DESCRIPTION OF THE DRAWINGS

Figs. 1(a) to 1(c) are diagrammatic sectional views illustrating steps of a procedure for producing one embodiment of the double-sided wiring circuit board according to the invention.
Figs. 2(d) to 2(f) are diagrammatic sectional views illustrating other steps of the procedure for producing the embodiment of the double-sided wiring circuit board according to the invention.
Figs. 3(g) to 3(i) are diagrammatic sectional views illustrating still other steps of the procedure for producing the embodiment of the double-sided wiring circuit board according to the invention.
Figs. 4(j) to 4(1) are diagrammatic sectional views illustrating further steps of the procedure for producing the embodiment of the double-sided wiring circuit board according to the invention.
Figs. 5(a) to 5(c) are diagrammatic sectional views illustrating examples of the shape of the via holes and examples of the method for forming them.
Figs. 6(a) to 6(c) are diagrammatic sectional views showing the structures of the double-sided wiring circuit boards of Examples 1 to 3.
Figs. 7(d) to 7(e) are diagrammatic sectional views showing the structures of the double-sided wiring circuit boards of Comparative Examples 1 and 2.
Figs. 8(a) to 8(f) are views illustrating a procedure for producing a double-sided wiring circuit board having a blind via structure by the conventional semiadditive wiring formation method.
Figs. 9(a) to 9(b) are diagrammatic sectional views illustrating the state of via holes according to conventional techniques into which an electroless-plating solution is penetrated.

The reference numerals or symbols used in the drawings denote the followings, respectively.
- 10a:: Insulating layer
- 10b:: Conductor layer
- 10M:: Deposit layer
- 10V:: Via hole
- 12:: Thin metal film

### DETAILED DESCRIPTION OF THE INVENTION

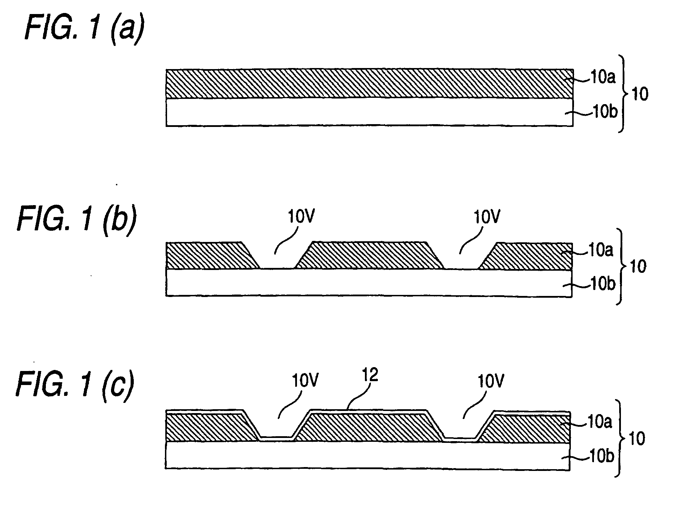

One embodiment of the double-sided wiring circuit board according to the invention will be explained below by reference to Figs. 1 to 7.

A process for producing this embodiment of the double-sided wiring circuit board is explained first. Figs. 1 to 4 are diagrammatic sectional views illustrating a procedure for producing one embodiment of the double-sided wiring circuit board according to the invention.

First, a two-layer substrate 10 is prepared which comprises an insulating layer 10a made of, e.g., a resin and, laminated therewith beforehand, a conductor layer 10b made of, e.g., a copper sheet as shown in Fig. 1(a). In the following explanation, the insulating layer 10a side of the two-layer substrate 10 is referred to as the upper side, while the conductor layer 10b side of the two-layer substrate 10 is referred to as the lower side. The insulating layer 10a and the conductor layer 10b need not necessarily have been laminated with each other beforehand. The insulating layer 10a and the conductor layer 10b may be press-bonded to each other or may be bonded to each other with an adhesive or the like.

Here, via holes (through-holes) 10V are formed in given positions in the insulating layer 10a as shown in Fig. 1(b) .

The via holes 10V each have an inner circumferential wall which inclines in a tapered manner so that the diameter of the via hole 10 gradually increases from the lower end to the upper end. The lower ends of the via holes 10V are sealed by the conductor layer 10b (blind via structure). The shape of the via hole 10V and the method for forming them will be described in detail below.

Thereafter, an electroless-plating solution is used to form a thin metal film 12 on the upper side of the two-layer substrate 10 as shown in Fig. 1(c) . Thus, a thin metal film 12 is formed on the upper side of the insulating layer 10a, on the inner circumferential surfaces of the via holes 10V, and on those parts of the upper side surfaces of the conductor layer 10b that are located in the via holes 10V. The thin metal film 12 is used as a plating electrode in the electroplating, which will be described later. The thin metal film 12 may be formed by sputtering, vapor deposition, or another technique.

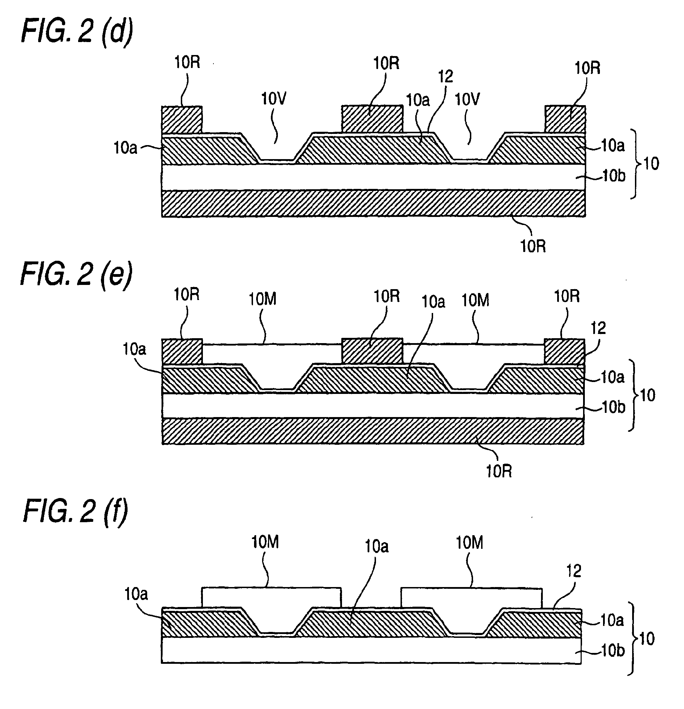

Subsequently, a plating resist layer 10R is formed in given regions on the surface of the thin metal film 12 as shown in Fig. 2(d). A plating resist layer 10R is formed also on the lower side surface of the conductor layer 10b.

As shown in Fig. 2(e), electroplating is then conducted using the thin metal film 12 as a plating electrode to thereby form a deposit layer 10M according to a wiring pattern which will be described below.

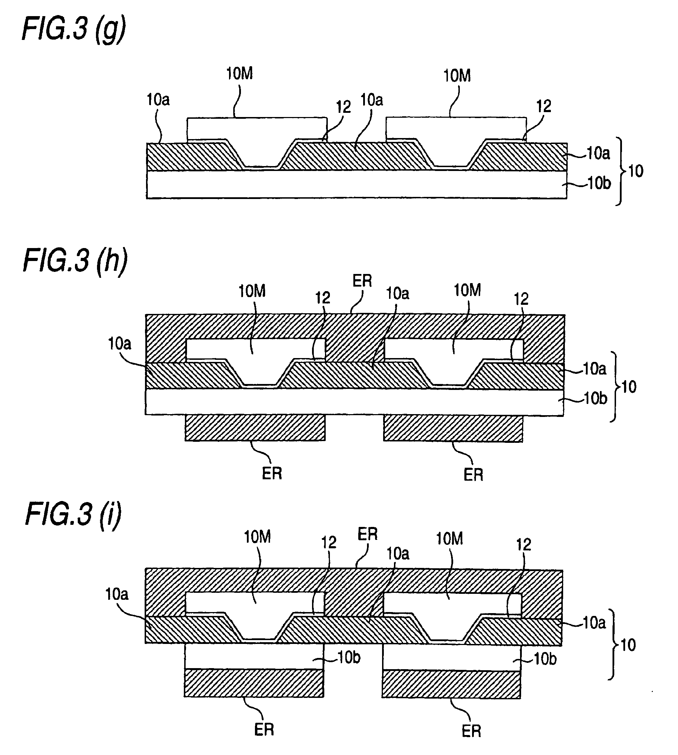

Thereafter, the plating resist layers 10R on the thin metal film 12 and on the conductor layer 10b are peeled off as shown in Fig. 2(f), and the thin metal film 12 exposed is removed by soft etching with a chemical as shown in Fig. 3(g).

Examples of the chemical for the soft etching are as follows. When the thin metal film is chromium, use is made of an aqueous permanganic acid solution, aqueous potassium ferricyanide solution, or the like. When the thin metal film is copper, use is made of an aqueous solution of sulfuric acid, nitric acid, or sodium persulfate, aqueous hydrogen peroxide solution, a mixture of two or more of these, or the like. When the thin metal film is nickel, use is made of a mixed solution of sulfuric acid and hydrogen peroxide or the like.

Subsequently, an etching resist layer ER is formed on the upper side of the two-layer substrate 10 and in given regions on the conductor layer 10b as shown in Fig. 3(h).

The conductor layer 10b is etched with a chemical such as, e.g., an aqueous ferric chloride solution as shown in Fig. 3 (i) .

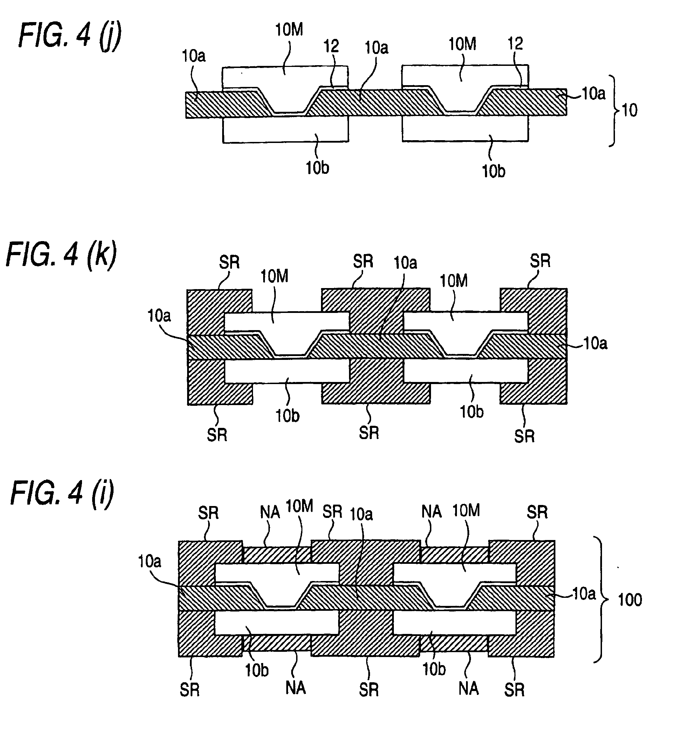

Thereafter, the etching resist layer ER is removed as shown in Fig. 4(j), whereby wiring patterns formed respectively by the deposit layer 10M and the conductor layer 10b are obtained on the upper and lower sides of the two-layer substrate 10, respectively.

Subsequently, an insulating cover layer SR is formed on each side of the insulating layer 10a so that the deposit layer 10M and the conductor layer 10b partly remain exposed as shown in Fig. 4(k). Thereafter, a deposit layer NA, e.g., a nickel (Ni)/gold (Au) layer, is formed by plating on the exposed parts of the deposit layer 10M and conductor layer 10b as shown in Fig. 4(1). Thus, the double-sided wiring circuit board 100 according to this embodiment is produced.

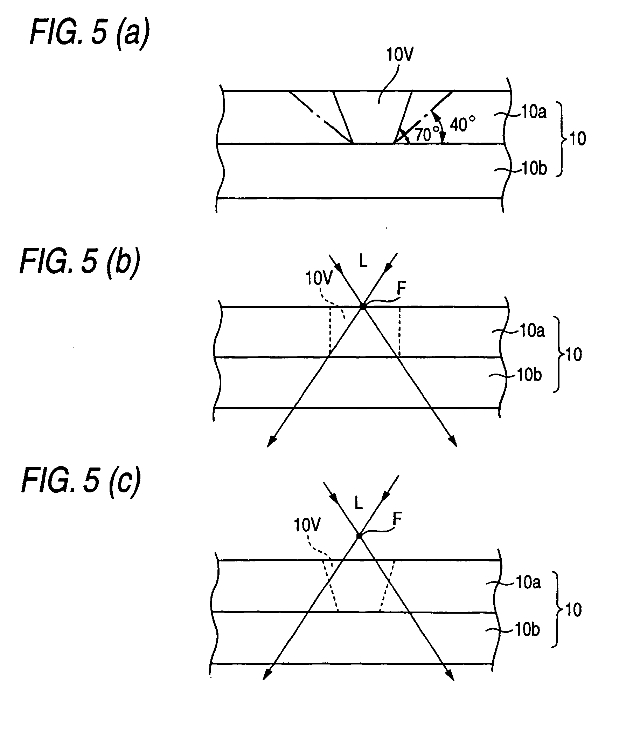

The shape of via holes 10V and the method for forming them are explained below in detail. Figs. 5 are diagrammatic sectional views showing examples of the shape of via holes and examples of methods for forming them.

As shown in Fig. 5(a), the inner circumferential wall of the via hole 10V shown in Fig. 1(b) has an angle of from 40° to 70° with the surface of the two-layer substrate 10. Methods for forming such a via hole 10V are as follows. Hereinafter, the angle between the inner circumferential wall of the via hole 10V and the surface of the two-layer substrate 10 is referred to as opening angle.

The via holes 10V are formed, for example, by a method using a laser beam or a method based on chemical etching.

In the case where the via hole 10V is formed with a laser beam, the energy density of the laser beam that is applied onto the insulating layer 10a is changed. Thus, the via hole 10V can be formed so as to have an opening angle of from 40° to 70°.

For example, when a laser beam L is regulated so as to have a focus F just on the upper surface of the insulating layer 10a of Fig. 1(a) as shown in Fig. 5(b), then the laser beam L enters the insulating layer 10a with a high energy density. In this case, the opening angle of the via hole 10V is nearly a right angle as indicated by the broken lines in Fig. 5(b).

In contrast, when a laser beam L is regulated so as to have a focus F above the upper surface of the insulating layer 10a of Fig. 1(a) as shown in Fig. 5 (c), then the laser beam L enters the insulating layer 10a with a lower energy density than the laser beam L regulated so as to have a focus F just on the upper surface of the insulating layer 10a of Fig. 1(a). In this case, the opening angle of the via hole 10V is an acute angle. Namely, this via hole 10V has an inclined inner circumferential wall as indicated by the broken lines in Fig. 5(c).

The opening angle of the via hole 10V varies with the energy density of the laser beam L. Consequently, via holes 10V having an opening angle in the range of from 40° to 70° can be formed by applying a laser beam L to the insulating layer 10a while regulating the energy density thereof.

In the method shown in Figs. 5(c), the focus F of the laser beam L is shifted in order to regulate the energy density of the laser beam L. However, methods for energy density regulation should not be construed as being limited thereto, and the energy density of the laser beam L itself may be changed. Further, the focus F of the laser beam L may be shifted downward from the upper surface of the insulating layer 10a, though it is shifted upward in the method shown in Fig. 5(C).

On the other hand, the case in which via holes 10V are formed by chemical etching is explained. In the case where via holes 10V are formed by chemical etching, the insulating layer 10a is preferably a photosensitive material such as a photosensitive polyimide. In this case, the insulating layer 10a is exposed to light through a mask having a given pattern and then developed to thereby form via holes 10V. The opening angle of the via holes 10V is regulated by suitably changing the exposure amount, development temperature, development time, etc.

In the case where the insulating layer is not a photosensitive material, via holes 10V can be formed by laminating an etching resist having given openings to the insulating layer 10a and spraying an etchant thereon. In this case, an opening angle in the range of from 40° to 70° can be imparted to the via holes 10V by regulating the concentration of the etchant, the temperature of the etchant, the etching time, the spray pressure, etc.

As described above, in producing this embodiment of the double-sided wiring circuit board, via holes 10V are formed so as to have an opening angle in the range of from 40° to 70°. The bottoms of these via holes 10V hence have non-abrasive edges regardless of whether the insulating layer 10a has been laminated to the conductor layer 10b with an adhesive or not. Because of this, in the case where a thin metal film 12 is formed by electroless plating, air bubbles which have come into the via holes 10V are less apt to be trapped at the edges of the via hole bottoms. As a result, the deposit layer 10M is sufficiently prevented from having defects and a high-density wiring pattern is realized.

Furthermore, due to the tapered form of the via holes 10V, an electroless-plating solution and an electroplating solution have the improved ability to penetrate into the via holes 10. Consequently, the time period required for the electroless plating treatment and electroplating treatment can be shortened.

On the other hand, in the case where sputtering is used for forming the thin metal film 12 (sputtering film), the thin metal film 12 is apt to be formed in an even thickness on the inner circumferential surfaces of the via holes 10V because the inner circumferential wall of each via hole 10V inclines. As a result, the deposit layer 10M is sufficiently prevented from having defects and a high-density wiring pattern is realized.

The reasons why the opening angle of the via holes 10V has been regulated to 40° to 70° are explained.

In case where the opening angle of the via holes 10V is smaller than 40°, the ability of an electroless-plating solution and an electroplating solution to penetrate into the via holes 10V is improved. Furthermore, sputtering gives a thin metal film 12 which has improved thickness evenness on the inner circumferential surfaces of the via holes 10V. However, there are cases where the reduced bottom areas of the via holes 10V results in reduced reliability of electrical connection. In addition, since the upper-end openings of these via holes 10 have an increased area, there is the possibility that short-circuiting with an adjacent wiring might occur.

On the other hand, in the case where the opening angle of the via holes 10V is larger than 70°, the ability of an electroless-plating solution to penetrate into the via holes 10V is reduced. There are hence cases where air bubbles are trapped at the edges of the bottoms of the via holes 10V and these parts cannot be coated by electroless plating. Furthermore, there are cases where sputtering gives a thin metal film 12 which, on the inner circumferential surfaces of the via holes 10V, has unevenness of thickness or has holes.

For those reasons, in this embodiment of the double-sided wiring circuit board, the opening angle of the via holes 10V has been regulated so as to be in the range of from 40° to 70°.

This double-sided wiring circuit board 100 shown as an embodiment has a blind via structure. In this case, since the via holes 10V are filled with the thin metal film 12 and the deposit layer 10 as described above, another wiring pattern can be superposed on the wiring pattern comprising the deposit layer M. It is also possible to minimize the size of the via holes 10V to thereby reduce the overall size of a product or heighten the degree of freedom of design.

This double-sided wiring circuit board 100 shown as an embodiment may be a flexible double-sided wiring circuit board. In this case, the double-sided wiring circuit board 100 can be used in various fields including electronic appliances and information appliances.

In this embodiment, the insulating layer 10a corresponds to the insulating layer, the conductor layer 10b corresponds to the conductor layer, the thin metal film 12 corresponds to the thin metal film, and the via holes 10V correspond to the through-holes. Furthermore, the deposit layer 10M corresponds to the deposit layer formed by electroplating, and the thin metal film 12 corresponds to the film deposited by electroless plating and to the film deposited by sputtering. Moreover, the conductor layer 10b corresponds to the first conductor layer, the deposit layer 10M corresponds the second conductor layer, and the insulating layer 10a corresponds to the flexible resin.

### EXAMPLES

The present invention will be illustrated in greater detail with reference to the following Examples and Comparative Examples, but the invention should not be construed as being limited thereto.

### EXAMPLE 1

A double-sided wiring circuit board according to Example 1 was produced by the following method. The procedure used for producing the double-sided wiring circuit board was the same as described above.

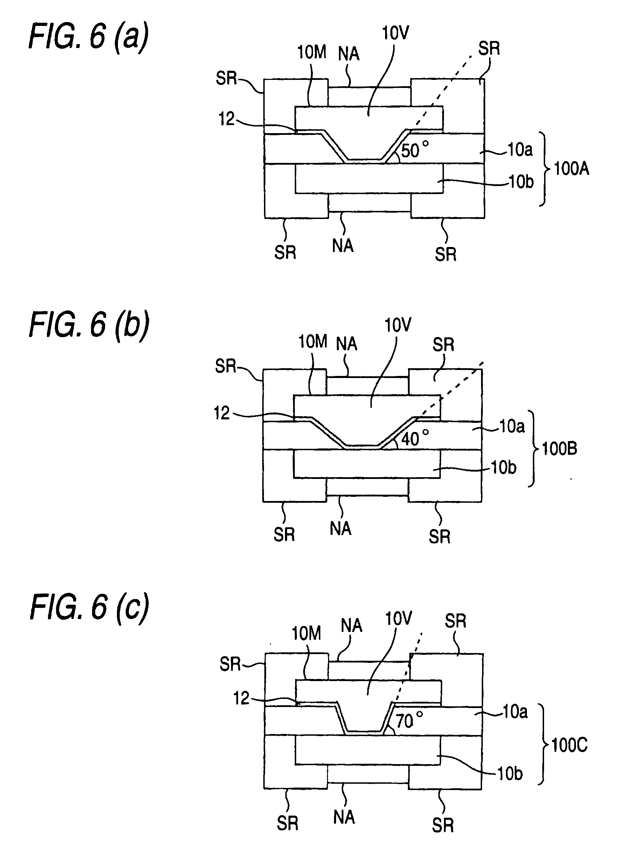

Fig. 6(a) is a diagrammatic sectional view illustrating the structure of the double-sided wiring circuit board of Example 1.

First, a two-layer substrate 10 composed of an insulating layer 10a and a conductor layer 10b was prepared. The insulating layer 10a were made of a polyimide having a thickness of 25 µm, and the conductor layer 10b were made of rolled copper having a thickness of 18 µm.

Subsequently, a laser beam L was applied to a given position of the two-layer substrate 10 in order to form each via hole 10V. The irradiation with the laser beam L was conducted in such a manner that the laser beam L had a focus F at a position shifted upward from the surface of the insulating layer 10a by 1.5 mm in the irradiation axis direction. The laser beam L in the state of having a low energy density was hence caused to enter the insulating layer 10a. As a result, via holes 10V having a lower-end diameter of 100 µm and an opening angle of 50° were formed.

In this double-sided wiring circuit board, the bottom of each via hole 10V is sealed with the conductor layer 10b. Namely, this wiring circuit board has a blind via structure.

Subsequently, a thin metal film 12 (sputtering film) made of chromium (Cr) having a thickness of 300 Å and copper having a thickness of 800 Å was formed by sputtering on the upper side of the insulating layer 10a, on the inner circumferential surfaces of the via holes 10V, and on those parts of the upper surface of the conductor layer 10b that were located in the via holes 10V.

Thereafter, a plating resist layer 10R having a thickness of 15 µm was formed in given regions on the surface of the thin metal film 12 by photolithography. Electrolytic copper plating was then conducted to form a 10 µm-thick deposit layer 10M having a minimum width of 30 µm and a minimum spacing of 30 µm. Thereafter, the plating resist layer 10R was peeled off, and the thin metal film 12 exposed was removed by soft etching.

An etching resist layer ER having a thickness of 15 µm was formed in given regions on the surface of the conductor layer 10b of the two-layer substrate 10. This etching resist layer ER was formed by photolithography.

Subsequently, etching was conducted to thereby form a conductor layer 10b having a minimum width of 70 µm and a minimum spacing of 70 µm. Thereafter, the etching resist layer ER was removed to thereby form wiring patterns respectively made of the deposit layer 10M and the conductor layer 10b.

Finally, insulating cover layers SR were formed in given regions on the substrate in which the wiring patterns had been completed, and those parts of the deposit layer 10M which were exposed and to serve as terminals were plated with a nickel (Ni)/gold (Au) deposit NA. Thus, a double-sided wiring circuit board 100A according to Example 1 was obtained. As shown in Fig. 6(a), the opening angle of the via holes 10V in the double-sided wiring circuit board 100A of Example 1 was 50°.

### EXAMPLE 2

A double-sided wiring circuit board according to Example 2 was produced in the same manner as for the double-sided wiring circuit board 100A of Example 1, except the following.

Fig. 6(b) is a diagrammatic sectional view illustrating the structure of the double-sided wiring circuit board of Example 2.

In producing the double-sided wiring circuit board according to Example 2, via holes 10V were formed in the following manner.

A laser beam L was applied onto a given position of the two-layer substrate 10 in order to form each via hole 10V. The irradiation with the laser beam L was conducted in such a manner that the laser beam L had a focus F at a position shifted upward from the surface of the insulating layer 10a by 2.0 mm in the irradiation axis direction. As a result, via holes 10V (blind vias) having a bottom diameter of 100 µm and an opening angle of 40° were formed.

Thus, a double-sided wiring circuit board 100B according to Example 2 was obtained. As shown in Fig. 6 (b), the opening angle of the via holes 10V in the double-sided wiring circuit board 100B of Example 2 was 40°.

### EXAMPLE 3

A double-sided wiring circuit board according to Example 3 was produced in the same manner as for the double-sided wiring circuit board 100A of Example 1, except the following.

Fig. 6(c) is a diagrammatic sectional view illustrating the structure of the double-sided wiring circuit board of Example 3.

In producing the double-sided wiring circuit board according to Example 3, via holes 10V were formed in the following manner.

A laser beam L was applied onto a given position of the two-layer substrate 10 in order to form each via hole 10V. The irradiation with the laser beam L was conducted in such a manner that the laser beam L had a focus F at a position shifted upward from the surface of the insulating layer 10a by 0.5 mm in the irradiation axis direction. As a result, via holes 10V (blind vias) having a bottom diameter of 100 µm and an opening angle of 70° were formed.

Thus, a double-sided wiring circuit board 100C according to Example 3 was obtained. As shown in Fig. 6 (c), the opening angle of the via holes 10V in the double-sided wiring circuit board 100C of Example 3 was 70°.

### COMPARATIVE EXAMPLE 1

A double-sided wiring circuit board according to Comparative Example 1 was produced in the same manner as for the double-sided wiring circuit board 100A of Example 1, except the following.

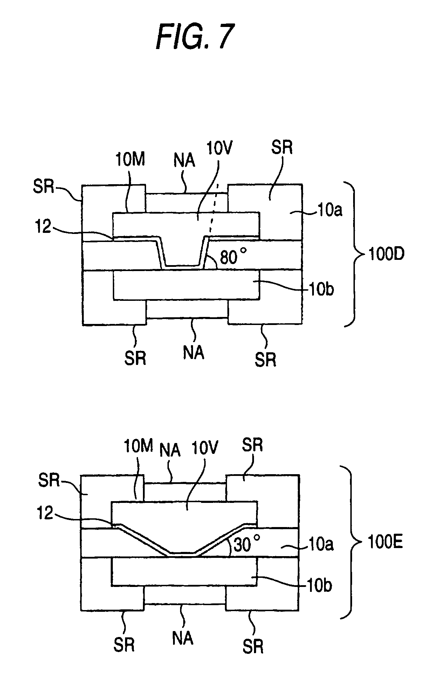

Fig. 7 (d) is a diagrammatic sectional view illustrating the structure of the double-sided wiring circuit board of Comparative Example 1.

In producing the double-sided wiring circuit board according to Comparative Example 1, via holes 10V were formed in the following manner.

A laser beam L was applied onto a given position of the two-layer substrate 10 in order to form each via hole 10V. The irradiation with the laser beam L was conducted in such a manner that the laser beam L had a focus F at a position just on the surface of the insulating layer 10a. As a result, via holes 10V (blind vias) having a bottom diameter of 100 µm and an opening angle of 80° were formed.

Thus, a double-sided wiring circuit board 100D according to Comparative Example 1 was obtained. As shown in Fig. 7(d), the opening angle of the via holes 10V in the double-sided wiring circuit board 100D of Comparative Example 1 was 80°.

### COMPARATIVE EXAMPLE 2

A double-sided wiring circuit board according to Comparative Example 2 was produced in the same manner as for the double-sided wiring circuit board 100A of Example 1, except the following.

Fig. 7(e) is a diagrammatic sectional view illustrating the structure of the double-sided wiring circuit board of Comparative Example 2.

In producing the double-sided wiring circuit board according to Comparative Example 2, via holes 10V were formed in the following manner.

A laser beam L was applied onto a given position of the two-layer substrate 10 in order to form each via hole 10V. The irradiation with the laser beam L was conducted in such a manner that the laser beam L had a focus F at a position shifted upward from the surface of the insulating layer 10a by 2.5 mm in the irradiation axis direction. As a result, via holes 10V (blind vias) having a bottom diameter of 100 µm and an opening angle of 30° were formed.

Thus, a double-sided wiring circuit board 100E according to Comparative Example 2 was obtained. As shown in Fig. 7(e), the opening angle of the via holes 10V in the double-sided wiring circuit board 100E of Comparative Example 2 was 30°.

### Test

Each of the double-sided wiring circuit boards 100A to 100E of Examples 1 to 3 and Comparative Examples 1 and 2 was subjected to an oil dip test.

In the oil dip test, the double-sided wiring circuit boards 100A to 100E of Examples 1 to 3 and Comparative Examples 1 and 2 were repeatedly subjected to 1-minute immersion in a room-temperature silicone oil and 1-minute immersion in a 260°C silicone oil, ten times in total. The double-sided wiring circuit boards 100A to 100E which had undergone the immersion were examined for short-circuiting in the wiring patterns of the conductors (the conductor layer 10b and the deposit layer 10M) and for any change in conductor resistance. The reliability of the conductors can be thus evaluated.

### Evaluation

As a result of the oil dip test, no short-circuiting was observed in the conductor wiring patterns in each of the double-sided wiring circuit boards 100A to 100C of Examples 1 to 3 even after the oil dip test. Furthermore, no change in conductor resistance was observed. It was thus ascertained that satisfactory conductor reliability had been obtained.

In contrast, in the double-sided wiring circuit board 100D of Comparative Example 1, a failure of conduction through the conductors occurred after the oil dip test due to a failure in the deposit layer 10M. The failure in the deposit layer 10M was found to be attributable to air bubbles which had been trapped in the via holes 10V during the electroless plating for forming the thin metal film 12.

In the double-sided wiring circuit board 100E of Comparative Example 2, the via holes 10V each had an exceedingly large top area. Because of this, adjacent via holes 10V overlapped each other, resulting in short-circuiting.

It can be seen from the test results and evaluations given above that the opening angle of the via holes 10V in the double-sided wiring circuit boards is desirably from 40° to 70°.

By forming via holes 10V while regulating the opening angle thereof so as to be within that range, a double-sided wiring circuit board can be obtained in which the deposit layer formed by plating is sufficiently prevented from having a failure and which can realize high-density wiring patterns.

The invention is useful in providing a double-sided wiring circuit board in which conductor layers disposed on the respective side are electrically connected through via holes and a process for producing the wiring circuit board.

While the present invention has been described in detail and with reference to specific embodiments thereof, it will be apparent to one skilled in the art that various changes and modifications can be made therein without departing from the spirit and scope thereof.

This application is based on Japanese patent application No. 2003-298283 filed August 22, 2003, the contents thereof being herein incorporated by reference.

## Claims

1. A double-sided wiring circuit board which comprises:
an insulating layer having a through-hole formed therein and having a first side and a second side;
a conductor layer formed on the first side of the insulating layer;
a thin metal film formed on the second side of the insulating layer, on the inner circumferential surface of the through-hole, and on the part of the conductor layer that is located in the through-hole; and
a deposit layer formed by electroplating on the thin metal film,
wherein the through-hole has an inner circumferential wall which inclines so that the inner diameter of the hole gradually increases from the first side to the second side of the insulating layer, and
wherein the angle of the inclination between the first side of the insulating layer and the inner circumferential wall being from 40° to 70°.

2. The double-sided wiring circuit board of claim 1, wherein the thin metal film is a film deposited by electroless plating.

3. The double-sided wiring circuit board of claim 1, wherein the thin metal film is a film deposited by sputtering.

4. A process for producing a double-sided wiring circuit board which comprises the steps of:
preparing a two-layer substrate comprising an insulating layer having a first side and a second side and a first conductor layer formed on the first side of the insulating layer;
forming a through-hole in the insulating layer so as to expose the first conductor layer,
forming a thin metal film on the second side of the insulating layer, on the inner circumferential surface of the through-hole, and on the part of the first conductor layer that is located in the through-hole; and
depositing a second conductor layer by electroplating on the thin metal film,
wherein the through-hole forming step includes a step of forming an inner circumferential wall of the through-hole so as to incline at an angle of from 40° to 70° with the first side of the insulating layer so that the inner diameter of the hole gradually increases from the first side to the second side of the insulating layer.

5. The process for producing a double-sided wiring circuit board of claim 4, wherein the thin metal film is formed by electroless plating.

6. The process for producing a double-sided wiring circuit board of claim 4, wherein the thin metal film is formed by sputtering.

7. The process for producing a double-sided wiring circuit board of any one of claims 4 to 6, wherein the insulating layer is formed from a flexible resin.
